# EUROPEAN PATENT APPLICATION

(11) **EP 4 822 377 A1**
(43) Date of publication of application: **14.10.2026**
(21) Application number: 24899120.0
(22) Date of filing: 28.04.2024
(51) Int. Cl.: G01R 31/69, H04N 5/765, H04N 17/04

(54) **MISPLUG DETECTION METHOD AND APPARATUS FOR HDMI DEVICE INTERFACE, AND DEVICE AND STORAGE MEDIUM**

(30) Priority: 07.12.2023 CN 202311687618
(71) Applicant: Zhejiang Uniview Technologies Co., Ltd., Hangzhou, Zhejiang 310051 (CN)
(72) Inventor: LV, Tianao, Hangzhou, Zhejiang 310051 (CN); XU, Xiaojun, Hangzhou, Zhejiang 310051 (CN); YANG, Ziqi, Hangzhou, Zhejiang 310051 (CN)
(74) Representative: De Ros, Alberto
(86) International application number: PCT/CN2024/090373
(87) International publication number: WO 2025/118468

(57) **Abstract**

The present disclosure relates to the technical field of device detection. Provided are a misplug detection method and apparatus for an HDMI device interface, and a device and a storage medium. The method comprises: acquiring a cable plugging signal corresponding to a target interface in an HDMI device; on the basis of the cable plugging signal, determining a cable plugging result corresponding to the target interface; and on the basis of the cable plugging result corresponding to the target interface and a target pin signal, determining a misplug detection result corresponding to the target interface.

## Description

### CROSS-REFERENCES TO RELATED APPLICATIONS

The present application claims priority to Chinese Patent Application No. 2023116876185, filed on December 07, 2023, entitled "Misplug Detection Method and Apparatus for HDMI Device Interface, and Device and Storage Medium", which is hereby incorporated by reference in its entirety.

### FIELD

The present application relates to the field of device testing technology, and in particular to a misplug detection method and apparatus for HDMI device interface, and a device and a storage medium.

### BACKGROUND

When multiple high definition multimedia interface (HDMI) devices are networked, output interfaces of each HDMI device need to be connected to input interfaces of other devices through cables. However, due to the large number of interfaces that need to be connected and the large number of cables that need to be plugged between them, the silk screen printing of the output or input interfaces is easily obscured by the cables. At the same time, the input and output interfaces of HDMI devices are the same, which may easily lead to the phenomenon of misplug of the output and input interfaces of various HDMI devices. It is difficult to check each cable one by one, resulting in low efficiency in detecting misplug of interfaces.

### BRIEF SUMMARY

The present application provides a misplug detection method and apparatus for HDMI device interface, and a device and a storage medium, to solve the problem of low efficiency in detecting misplug of interfaces in related art.

The present application provides a misplug detection method for definition multimedia interface (HDMI) device interface, used for any HDMI device in a network, including:
obtaining a cable plug-in signal corresponding to a target interface in an HDMI device;
determining, based on the cable plug-in signal, a cable plug-in result corresponding to the target interface; and
determining, based on the cable plug-in result and a target pin signal corresponding to the target interface, a misplug detection result corresponding to the target interface.

The present application further provides a misplug detection apparatus for HDMI device interface, used for any high-definition multimedia interface (HDMI) device in a network, including:
an obtaining module, configured for obtaining a cable plug-in signal corresponding to a target interface in an HDMI device;
a determining module, configured for determining, based on the cable plug-in signal, a cable plug-in result corresponding to the target interface; and
a misplug detection module, configured for determining, based on the cable plug-in result and a target pin signal corresponding to the target interface, a misplug detection result corresponding to the target interface.

The present application also provides an electronic device, including a memory, a processor, and a computer program stored in the memory and executable on the processor, where the processor executes the computer program to implement the misplug detection method for HDMI device interface as described above.

The present application also provides a non-transitory computer-readable storage medium having a computer program stored thereon, which, when executed by a processor, implements the misplug detection method for HDMI device interface as described above.

### BRIEF DESCRIPTION OF THE DRAWINGS

FIG. 1 is a schematic flowchart of a misplug detection method for HDMI device interface according to an embodiment of the present application;
FIG. 2 is a schematic diagram of connection of a target interface according to an embodiment of the present application;
FIG. 3 is a schematic diagram of misplug detection process of an output interface according to an embodiment of the present application;
FIG. 4 is a schematic diagram of misplug detection process of an input interface according to an embodiment of the present application;
FIG. 5 is a schematic structural diagram of a misplug detection apparatus for HDMI device interface according to an embodiment of the present application; and
FIG. 6 is a schematic structural diagram of an electronic device according to an embodiment of the present application.

### DETAILED DESCRIPTION

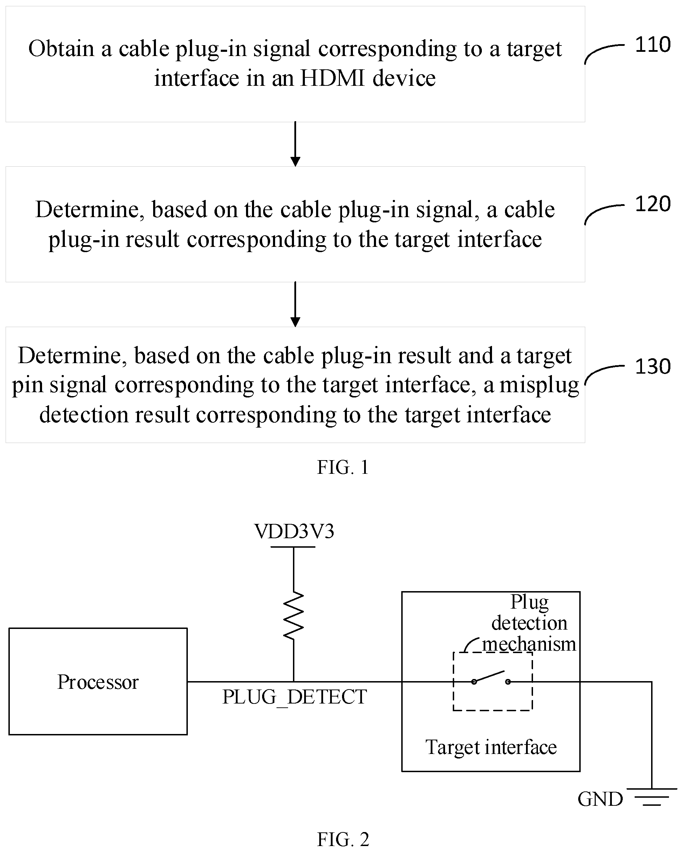

Embodiments of the present application provide a misplug detection method for HDMI device interface, used for any high-definition multimedia interface (HDMI) device in a network. FIG. 1 is a schematic flowchart of a misplug detection method for HDMI device interface according to an embodiment of the present application. As shown in FIG. 1, the method includes:

Step 110: obtain a cable plug-in signal PLUG_DETECT corresponding to a target interface in the HDMI device.

Optionally, the target interface may be an output interface or an input interface of an HDMI device. There is no male or female distinction between the output interface and the input interface. When various HDMI devices are networked, the interface may only be distinguished as an output interface or an input interface by the silk screen printing on the interface. The target interface is an HDMI connector. FIG. 2 is a schematic diagram of connection of a target interface according to an embodiment of the present application. As shown in FIG. 2, the target interface is provided with a plug detection mechanism, which may be a reed or a relay. When the plug detection mechanism is a reed, one end of the reed is connected to one end of the pull-up resistor R1 and a processor in the HDMI device. The reed is a spring, and the different connection states of the other end of the reed to the ground terminal correspond to different cable plug-in signals PLUG_DETECT, which in turn correspond to different cable plug-in results in the target interface. When the plug detection mechanism is a relay, a first end of the relay is connected to one end of the pull-up resistor R1 and the processor in the HDMI device, and a second end of the relay is connected to the ground terminal. Different states of the relay correspond to different cable plug-in signals PLUG_DETECT, which in turn correspond to different cable plug-in results in the target interface.

Optionally, the processor may be a central processing unit (CPU) or a micro controller unit (MCU).

Step 120: determine, based on the cable plug-in signal PLUG_DETECT, a cable plug-in result corresponding to the target interface.

Specifically, after obtaining the cable plug-in signal PLUG_DETECT corresponding to the target interface, the cable plug-in result corresponding to the target interface, that is, whether a cable is plugged into the target interface, may be determined by the level change of the cable plug-in signal PLUG_DETECT.

Further, determining, based on the cable plug-in signal PLUG_DETECT, a cable plug-in result corresponding to the target interface includes:
obtaining a preset cable plug-in signal PLUG_DETECT; and
matching the cable plug-in signal PLUG_DETECT with the preset cable plug-in signal, and determining the cable plug-in result corresponding to the target interface based on a matching result.

Specifically, in case that the cable plug-in signal PLUG_DETECT matches the preset cable plug-in signal PLUG_DETECT, the cable plug-in result corresponding to the target interface is determined to be that no cable is plugged into the target interface. In case that the cable plug-in signal PLUG_DETECT does not match the preset cable plug-in signal PLUG_DETECT, the cable plug-in result corresponding to the target interface is determined to be that a cable is plugged into the target interface.

For example, as shown in FIG. 2, when the plug detection mechanism is a spring, in the initial state, when no cable is plugged into the target interface of the HDMI device, the other end of the spring is tilted upwards, that is, the other end of the spring is disconnected from the ground terminal. At this point, due to the power supply of the 3.3V power supply VDD3V3 and the voltage division effect of the pull-up resistor R1, the cable plug-in signal PLUG_DETECT detected by the processor is a high-level signal. After a cable is plugged into the target interface, the other end of the spring is pressed down to connect to the ground terminal. At this point, the ground terminal pulls the cable plug-in signal PLUG_DETECT down to a low level. When the plug detection mechanism is a relay, in the initial state, the relay is in the open state. At this point, the cable plug-in signal PLUG_DETECT detected by the processor is a high-level signal. After a cable is plugged into the target interface, the relay is in the closed state. At this point, the cable plug-in signal PLUG_DETECT detected by the processor is a low-level signal. That is, the preset cable plug-in signal PLUG_DETECT in the initial state is obtained. The preset cable plug-in signal PLUG_DETECT is a high-level signal. If it is detected that the cable plug-in signal PLUG_DETECT and the preset cable plug-in signal PLUG_DETECT are both high-level signals, it can be determined that the cable plug-in result indicates that no cable is plugged into the target interface. If it is detected that the cable plug-in signal PLUG_DETECT and the preset cable plug-in signal PLUG_DETECT are mismatched, and the cable plug-in signal PLUG_DETECT is a low-level signal, it can be determined that the cable plug-in result indicates that a cable is plugged into the target interface.

Step 130: determine, based on the cable plug-in result and a target pin signal corresponding to the target interface, a misplug detection result corresponding to the target interface.

Specifically, when the cable plug-in results corresponding to the target interface are different, the target pin signals corresponding to the target interface are different. By combining the cable plug-in results and the target pin signals, the misplug detection results corresponding to the target interface may be determined, that is, it may be determined whether a misplug phenomenon exists in the target interface. If a misplug phenomenon exists, the corresponding misplug state may be further determined.

Further, determining, based on the cable plug-in result and a target pin signal corresponding to the target interface, a misplug detection result corresponding to the target interface includes:
determining, based on the cable plug-in result corresponding to the target interface, a power switch state corresponding to the target interface;
determining, based on the power switch state and the cable plug-in result, the target pin signal corresponding to the target interface; and
determining, based on the target pin signal, the misplug detection result corresponding to the target interface.

Specifically, the target interface is connected to a 5V power supply DDC_5V via a power switch. When the cable plug-in results corresponding to the target interface are different, the power switch state varies. By combining the power switch state and the cable plug-in results, different target pin signals may be obtained. Based on the target pin signals, it may be determined whether a misplug phenomenon exists in the target interface. If a misplug phenomenon exists, the misplug state may be accurately located based on the target pin signals, assisting wiring personnel in correcting the misplug.

Further, determining, based on the cable plug-in result corresponding to the target interface, a power switch state corresponding to the target interface includes:
in case that the cable plug-in result indicates that a cable is plugged into the target interface, determining the power switch state corresponding to the target interface to be in the closed state; and
in case that the cable plug-in result indicates that no cable is plugged into the target interface, determining the power switch state corresponding to the target interface to be in the open state.

Specifically, if the cable plug-in result indicates that a cable is plugged into the target interface, the processor may control the power switch connected to the target interface to be in the closed state, that is, to turn on a circuit between the 5V power supply DDC_5V and the target interface. If the cable plug-in result indicates that no cable is plugged into the target interface, the processor may control the power switch connected to the target interface to be in the open state, that is, to disconnect the circuit between the 5V power supply DDC_5V and the target interface.

Further, determining, based on the power switch state and the cable plug-in result, the target pin signal corresponding to the target interface includes:
determining, based on the power switch state, a power supply signal in the target pin signal; and
determining, based on the cable plug-in result and the power supply signal, a hot-plug detection signal in the target pin signal.

Specifically, the target interface is an HDMI connector, and the target pin signal includes a power supply signal and a hot-plug detection (HPD) signal, which may be obtained from pin 18 of the HDMI connector. For example, in the initial state, the power supply signal corresponding to the target interface defaults to a low-level signal. If the target interface is an output interface, after a power switch connected to the output interface is in the closed state, the 5V power supply DDC_5V of the output interface pulls up the power supply signal of the output interface to a high level. At the same time, the 5V power supply DDC_5V of the output interface supplies power to the 5V power supply DDC_5V of the opposite interface through a cable. It should be noted that after a cable is plugged into the output interface, the power supply signal of the output interface may be pulled up to a high level regardless of whether the opposite interface is connected or not. If the target interface is an input interface, after a power switch connected to the input interface is in the closed state, the input interface receives the power supply signal output by the 5V power supply DDC_5V of the opposite interface through pin 18, and further pulls up the power supply signal of the input interface to a high level. It should be noted that the power supply signal of the input interface may be pulled up to a high level only when the opposite interface connected to the input interface is an output interface. Furthermore, regardless of whether the target interface is an input interface or an output interface, if no cable is plugged into the target interface, the power supply signal corresponding to the target interface is a low level signal.

In addition, the HPD signal may be obtained from pin 19 of the HDMI connector. For example, in the initial state, the HPD signal corresponding to the target interface is a low level signal. If the target interface is an input interface, the power supply signal of the input interface is pulled up to a high level, and the power supply signal may pull up the HPD signal of the input interface to a high level. If the target interface is an output interface, the HPD signal of the output interface may be pulled up to a high level by the HPD signal of the input interface only when the opposite interface connected to the output interface is an input interface. Otherwise, the HPD signal of the output interface is a low level signal.

Further, determining, based on the target pin signal, the misplug detection result corresponding to the target interface includes:
obtaining a preset pin signal list, wherein the preset pin signal list comprises a corresponding relationship between a pin signal and a plugging state; and
determining, based on the corresponding relationship between the pin signal and the plugging state in the preset pin signal list, a plugging state corresponding to a pin signal matching the target pin signal as the misplug detection result corresponding to the target interface.

Specifically, after determining the target pin signal, a preset pin signal list may be obtained. The preset pin signal list includes a corresponding relationship between the plugging state and the pin signal. The target pin signal is matched with each pin signal in the preset pin signal list. After a pin signal identical to the target pin signal is matched, the plugging state corresponding to the pin signal is determined as the misplug detection result corresponding to the target interface based on the corresponding relationship between the plugging state and the pin signal. If the plugging state is an output-to-input state, which indicates that no misplug phenomenon exists in the target interface. If the plugging state is a state other than the output-to-input state, it indicates that a misplug phenomenon exists in the target interface. The specific misplug state may be determined based on the plugging state, thereby achieving accurate location of the misplug.

Optionally, the preset pin signal list is shown in Table 1. As can be seen from Table 1, the plugging states may include output-to-input, output-to-output, input-to-input, output-not-connected, and input-not-connected, where:

(1) The output-to-input state is a correct plugging state, indicating that an output interface of an HDMI device is connected to the input interface of another HDMI device through a cable, or an input interface of the HDMI device is connected to an output interface of another HDMI device through a cable. In case that the output interface of the HDMI device is connected to the input interface of another HDMI device through a cable, after a cable is plugged into the output interface, a power switch corresponding to the output interface is in the closed state, and the 5V power supply DDC_5V pulls up the power supply signal of the output interface to a high level. At the same time, the 5V power supply DDC_5V of the output interface supplies power to the 5V power supply DDC_5V of the input interface of the other HDMI device through a cable. The 5V power supply DDC_5V pulls up the power supply signal of the input interface to a high level. Simultaneously, the 5V power supply DDC_5V of the input interface pulls up the HPD signal of the input interface to a high level. The HPD signal of the input interface pulls up the HPD signal of the output interface to a high level.

(2) The output-to-output state is a misplug state, indicating that an output interface of an HDMI device is connected to an output interface of another HDMI device through a cable. After a cable is plugged between the two output interfaces, the power switch corresponding to each output interface is in the closed state, and the 5V power supply DDC_5V pulls up the power supply signal of the output interface to a high level. Since the HPD signal of the input interface may not pull up the HPD signal of each output interface to a high level, the HPD signal corresponding to each of the two output interfaces remains at a low level.

(3) The input-to-input state is a misplug state, indicating that an input interface of an HDMI device is connected to an input interface of another HDMI device through a cable. After a cable is plugged between the two input interfaces, the power switch corresponding to each input interface is in the closed state. However, no output interface supplies power to the 5V power supply DDC_5V of each input interface. Therefore, the power supply signal of each of the two input interfaces remains at a low level. At the same time, since the power supply signal of each of the two input interfaces is at a low level, the HPD signal of each input interface cannot be pulled up to a high level. Therefore, the HPD signal corresponding to each of the two input interfaces remains at a low level.

(4) The output-not-connected state is a misplug state, indicating that a cable is plugged into an output interface of the HDMI device, while the other end of the cable is not connected to any HDMI device. At this time, since a cable is plugged into the output interface, the power switch corresponding to the output interface is in the closed state. The 5V power supply DDC_5V pulls up the power supply signal of the output interface to a high level. At the same time, since no HDMI device is connected to the other end of the cable, the HPD signal of the input interface may not pull up the HPD signal of the output interface to a high level. Therefore, the HPD signal of the output interface remains at a low level.

(5) The input-not-connected state is a misplug state, indicating that a cable is plugged into an input interface of an HDMI device, while the other end of the cable is not connected to any HDMI device. At this time, since a cable is plugged into the input interface, the power switch corresponding to the input interface is in the closed state. However, no output interface supplies power to the 5V power supply DDC_5V of the input interface. Therefore, the power supply signal of the input interface remains at a low level. At the same time, since the power supply signal of the input interface is at a low level, the HPD signal of the input interface may not be pulled up to a high level. Therefore, the HPD signal corresponding to each input interface remains at a low level.

**Table 1**

| Plugging States | Output-to-Input | | Output-to-Output | | Input-to-Input | | Output-not-connected | Input-not-connected |
|---|---|---|---|---|---|---|---|---|
| Target interface | Output interface | Input interface | Output interface | Output interface | Input interface | Input interface | Output interface | Input interface |
| Power supple signal | high | high | high | high | low | low | high | low |
| HPD signal | high | high | low | low | low | low | low | low |

Furthermore, as shown in Table 1, the pin signals are the same when the plugging state is input-to-input and input-not-connected, and the pin signals are the same when the plugging state is the output-to-output state and the output-not-connected state. In this case, distinction may be made in combination with the cable plug-in results.

The method further includes:
in case that the cable plug-in result indicates that no cable is plugged into the target interface, or in case that the misplug detection result indicates that the target interface is misplugged, generating alarm information and sending the alarm information to an alarm device.

Specifically, if no cable is plugged into the target interface, or if it is determined through misplug detection that a misplug phenomenon exists in the target interface, the alarm information may be generated and sent to an alarm device to remind wiring personnel to plug in the cable or notify of abnormal cable connection. The alarm device may be an indicator light, a buzzer, and an intelligent voice broadcasting device, etc.

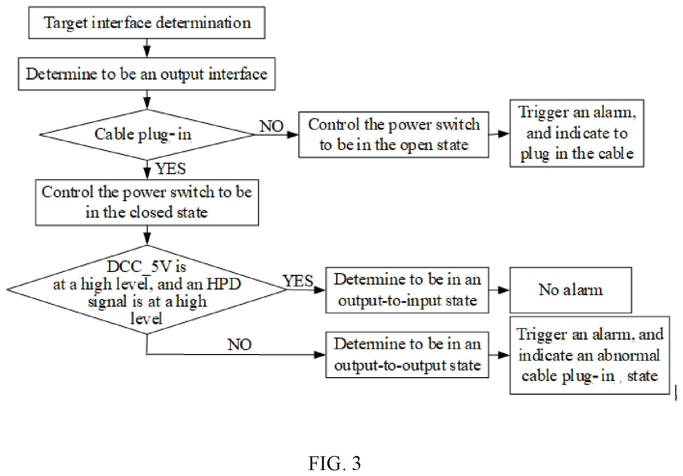

For example, FIG. 3 is a schematic diagram of misplug detection process of an output interface according to an embodiment of the present application. As shown in FIG. 3, when determining that the target interface of the HDMI device is an output interface, the cable plug-in signal PLUG_DETECT corresponding to the output interface is first obtained through a plug detection mechanism. If the cable plug-in signal PLUG_DETECT is a high level signal, it indicates that the cable plug-in result corresponding to the output interface indicates that no cable is plugged into the output interface. At this time, the alarm information may be generated and the alarm device may remind the wiring personnel to plug in the cable. If the cable plug-in signal PLUG_DETECT is at a low level, it indicates that the cable plug-in result corresponding to the output interface indicates that a cable is plugged into the output interface. In this case, the power switch of the output interface is closed, and the power supply signal and HPD signal for the output interface are obtained. If both the power supply signal and HPD signal are at a high level, it may be determined that the connection interface on the opposite side is an input interface. At this time, it is an output-to-input state, which is a correct plugging state, and no alarm is needed. If the power supply signal is at a high level while the HPD signal is at a low level, it may be determined that the connection interface on the opposite side is an output interface. At this time, it is an output-to-output state, which is a misplug state. The alarm information needs to be generated to remind the wiring personnel that the cable plug-in state is abnormal.

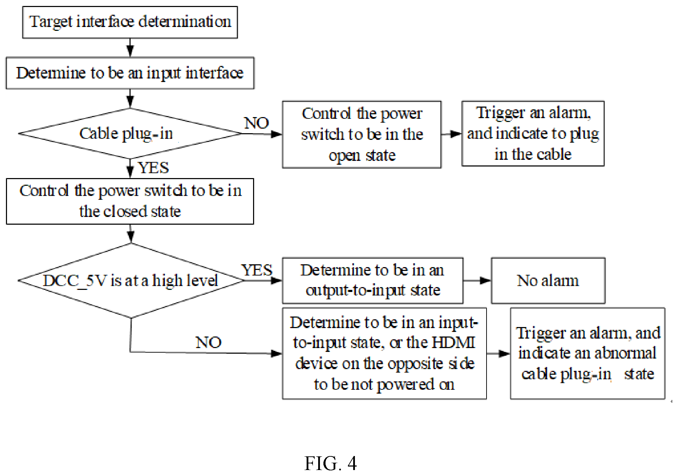

For example, FIG. 4 is a schematic diagram of misplug detection process of an input interface according to an embodiment of the present application. As shown in FIG. 4, when determining that the target interface of the HDMI device is an input interface, the cable plug-in signal PLUG_DETECT corresponding to the input interface is first obtained through a plug detection mechanism. If the cable plug-in signal PLUG_DETECT is a high level signal, it indicates that the cable plug-in result corresponding to the input interface indicates that no cable is plugged into the input interface. At this time, the alarm information may be generated and the alarm device may remind the wiring personnel to plug in the cable. If the cable plug-in signal PLUG_DETECT is at a low level, it indicates that the cable plug-in result corresponding to the input interface indicates that a cable is plugged into the input interface. In this case, the power switch of the input interface is closed, and the power supply signal for the input interface is obtained. If the power supply signal is at a high level, it may be determined that the connection interface on the opposite side is an output interface. At this time, it is a correct connection state, and no alarm is needed. If the power supply signal is at a low level, it indicates that the connection interface on the opposite side is an input interface or the HDMI device on the opposite side is not powered on. The alarm information should be generated to remind the wiring personnel that the cable plug-in state is abnormal.

In the misplug detection method for HDMI device interface provided in the embodiments of present application, after obtaining the cable plug-in signal PLUG_DETECT corresponding to the target interface in the HDMI device, the cable plug-in result corresponding to the target interface is determined by the level change of the cable plug-in signal PLUG_DETECT, and the misplug detection result corresponding to the target interface is automatically determined by combining the cable plug-in result and the target pin signal corresponding to the target interface. That is, whether the target interface is plugged in correctly or in various misplug states is automatically determined, improving the efficiency of misplug detection, and accurately locating the misplug phenomenon of HDMI devices in the network, thereby assisting wiring personnel to quickly identify cable misplug problems.

The misplug detection apparatus for HDMI device interface provided in the embodiments of present application is described below. The misplug detection apparatus for HDMI device interface described below and the misplug detection method for HDMI device interface described above may be referred to each other.

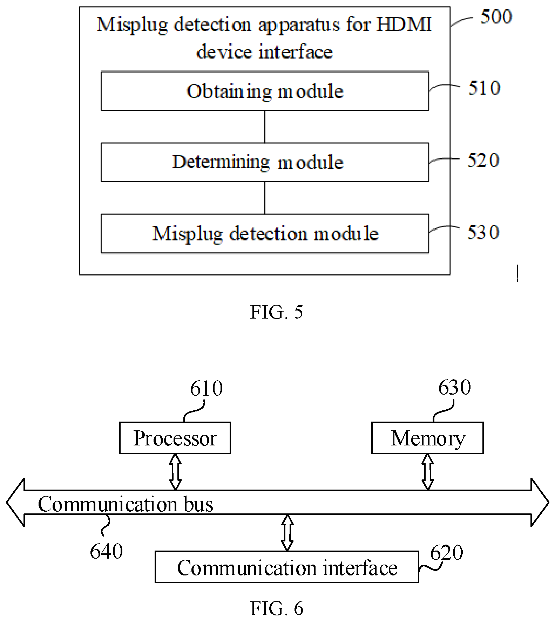

Embodiments of the present application also provide a misplug detection apparatus for HDMI device interface, applied to any high-definition multimedia interface (HDMI) device in a network. FIG. 5 is a schematic structural diagram of a misplug detection apparatus for HDMI device interface according to an embodiment of the present application. As shown in FIG. 5, the misplug detection apparatus 500 for HDMI device interface includes: an obtaining module 510, a determining module 520, and a misplug detection module 530.

The obtaining module 510 is configured for obtaining a cable plug-in signal PLUG_DETECT corresponding to a target interface in an HDMI device.

The determining module 520 is configured for determining, based on the cable plug-in signal PLUG_DETECT, a cable plug-in result corresponding to the target interface.

The misplug detection module 530 is configured for determining, based on the cable plug-in result and a target pin signal corresponding to the target interface, a misplug detection result corresponding to the target interface.

In the misplug detection apparatus for HDMI device interface provided in the embodiments of present application, after obtaining the cable plug-in signal PLUG_DETECT corresponding to the target interface in the HDMI device, the cable plug-in result corresponding to the target interface is determined by the level change of the cable plug-in signal PLUG_DETECT, and the misplug detection result corresponding to the target interface is automatically determined by combining the cable plug-in result and the target pin signal corresponding to the target interface. That is, whether the target interface is plugged in correctly or in various misplug states is automatically determined, improving the efficiency of misplug detection, and accurately locating the misplug phenomenon of HDMI devices in the network, thereby assisting wiring personnel to quickly identify cable misplug problems.

Optionally, the misplug detection module 530 is specifically configured for:
determining, based on the cable plug-in result corresponding to the target interface, a power switch state corresponding to the target interface;
determining, based on the power switch state and the cable plug-in result, the target pin signal corresponding to the target interface; and
determining, based on the target pin signal, the misplug detection result corresponding to the target interface.

Optionally, the misplug detection module 530 is specifically configured for:
in case that the cable plug-in result indicates that a cable is plugged into the target interface, determining the power switch state corresponding to the target interface to be in the closed state; and
in case that the cable plug-in result indicates that no cable is plugged into the target interface, determining the power switch state corresponding to the target interface to be in open state.

Optionally, the misplug detection module 530 is specifically configured for:
determining, based on the power switch state, a power supply signal in the target pin signal; and
determining, based on the cable plug-in result and the power supply signal, a hot-plug detection signal in the target pin signal.

Optionally, the misplug detection module 530 is specifically configured for:
obtaining a preset pin signal list, where the preset pin signal list comprises a corresponding relationship between a pin signal and a plugging state; and
determining, based on the corresponding relationship between the pin signal and the plugging state in the preset pin signal list, a plugging state corresponding to a pin signal that matches the target pin signal as the misplug detection result corresponding to the target interface.

Optionally, the determining module 520 is configured for:
matching the cable plug-in signal PLUG_DETECT with the preset cable plug-in signal, and determining the cable plug-in result corresponding to the target interface based on a matching result.

Optionally, the misplug detection apparatus 500 for HDMI device interface further includes an alarm module. The alarm module is specifically configured for:
in case that the cable plug-in result indicates that no cable is plugged into the target interface, or in case that the misplug detection result indicates that the target interface is misplugged, generating alarm information and sending the alarm information to an alarm device.

FIG. 6 illustrates a schematic structural diagram of an electronic device. As shown in FIG. 6, the electronic device may include: a processor 610, a communication interface 620, a memory 630, and a communication bus 640, where the processor 610, the communication interface 620, and the memory 630 communicate with each other through the communication bus 640. The processor 610 may call logic instructions in the memory 630 to execute the misplug detection method for HDMI device interface. The method includes:
obtaining a cable plug-in signal PLUG_DETECT corresponding to a target interface in the HDMI device;
determining, based on the cable plug-in signal PLUG_DETECT, a cable plug-in result corresponding to the target interface; and
determining, based on the cable plug-in result and a target pin signal corresponding to the target interface, a misplug detection result corresponding to the target interface.

Furthermore, the logic instructions in the aforementioned memory 630 may be implemented as software functional units and, when sold or used as independent products, may be stored in a computer-readable storage medium. Based on such understanding, the solutions of the present application in essence or a part of the solutions that contributes to the related art, or part of the solutions, may be embodied in the form of a software product, which is stored in a storage medium, including several instructions to cause a computer device (which may be a personal computer, server, or network device, etc.) to perform all or part of the steps of the methods described in the respective embodiments of the present application. The storage medium described above includes various media that may store program codes such as USB flash disk, mobile hard disk, read-only memory (ROM), random access memory (RAM), magnetic disk, or optical disk.

On the other hand, the present application also provides a computer program product, which includes a computer program that may be stored on a computer-readable storage medium. When the computer program is executed by a processor, the computer may execute the he misplug detection method for HDMI device interface provided in any of the above method embodiments. The method includes:
obtaining a cable plug-in signal PLUG_DETECT corresponding to a target interface in an HDMI device;
determining, based on the cable plug-in signal PLUG_DETECT, a cable plug-in result corresponding to the target interface; and
determining, based on the cable plug-in result and a target pin signal corresponding to the target interface, a misplug detection result corresponding to the target interface.

The present application also provides a non-transitory computer-readable storage medium having a computer program stored thereon, which, when executed by a processor, implements the misplug detection method for HDMI device interface as described above. The method includes:
obtaining a cable plug-in signal PLUG_DETECT corresponding to a target interface in an HDMI device;
determining, based on the cable plug-in signal PLUG_DETECT, a cable plug-in result corresponding to the target interface; and
determining, based on the cable plug-in result and a target pin signal corresponding to the target interface, a misplug detection result corresponding to the target interface.

The apparatus embodiments described above are merely illustrative. The units described as separate components may or may not be physically separate. The components shown as units may or may not be physical units, that is, they may be located in one place or distributed across multiple network units. Some or all of the modules may be selected to achieve the purpose of the embodiment according to actual needs. Those skilled in the art may understand and implement this without any creative effort.

Through the above description of the embodiments, those skilled in the art may clearly understand that each embodiment may be implemented by means of software plus necessary general-purpose hardware platform, or of course by hardware. Based on this understanding, the above technical solution, in essence or the part that contributes to the related art, may be embodied in the form of a software product. This computer software product may be stored in a computer-readable storage medium, such as ROM/RAM, magnetic disk, optical disk, etc., and includes several instructions to cause a computer device (which may be a personal computer, server, or network device, etc.) to execute the methods described in each embodiment or some parts of the embodiments.

Finally, it should be noted that the above embodiments are only used to illustrate the technical solutions of the present application, and are not intended to limit them. Although the present application has been described in detail with reference to the foregoing embodiments, those skilled in the art should understand that modifications may still be made to the technical solutions described in each of the foregoing embodiments, or equivalent substitutions may be made to some of the technical features. Such modifications or substitutions do not cause the essence of the corresponding technical solutions to deviate from the spirit and scope of the technical solutions of embodiments of the present application.

## Claims

1. A misplug detection method for high-definition multimedia interface (HDMI) device interface, used for any HDMI device in a network, comprising:
obtaining a cable plug-in signal corresponding to a target interface in an HDMI device;
determining, based on the cable plug-in signal, a cable plug-in result corresponding to the target interface; and
determining, based on the cable plug-in result and a target pin signal corresponding to the target interface, a misplug detection result corresponding to the target interface.

2. The method of claim 1, wherein determining, based on the cable plug-in result and the target pin signal corresponding to the target interface, the misplug detection result corresponding to the target interface comprises:
determining, based on the cable plug-in result corresponding to the target interface, a power switch state corresponding to the target interface;
determining, based on the power switch state and the cable plug-in result, the target pin signal corresponding to the target interface; and
determining, based on the target pin signal, the misplug detection result corresponding to the target interface.

3. The method of claim 2, wherein determining, based on the cable plug-in result corresponding to the target interface, the power switch state corresponding to the target interface comprises:
in case that the cable plug-in result indicates that a cable is plugged into the target interface, determining the power switch state corresponding to the target interface to be in a closed state; and
in case that the cable plug-in result indicates that no cable is plugged into the target interface, determining the power switch state corresponding to the target interface to be in an open state.

4. The method of claim 2, wherein determining, based on the power switch state and the cable plug-in result, the target pin signal corresponding to the target interface comprises:
determining, based on the power switch state, a power supply signal in the target pin signal; and
determining, based on the cable plug-in result and the power supply signal, a hot-plug detection signal in the target pin signal.

5. The method of claim 2, wherein determining, based on the target pin signal, the misplug detection result corresponding to the target interface comprises:
obtaining a preset pin signal list, wherein the preset pin signal list comprises a corresponding relationship between a pin signal and a plugging state; and
determining, based on the corresponding relationship between the pin signal and the plugging state in the preset pin signal list, a plugging state corresponding to a pin signal that matches the target pin signal as the misplug detection result corresponding to the target interface.

6. The method of any of claims 1 to 5, wherein determining, based on the cable plug-in signal, the cable plug-in result corresponding to the target interface comprises:
obtaining a preset cable plug-in signal; and
matching the cable plug-in signal with the preset cable plug-in signal, and determining the cable plug-in result corresponding to the target interface based on a matching result.

7. The method of any of claims 1 to 5, further comprising:
in case that the cable plug-in result indicates that no cable is plugged into the target interface, or in case that the misplug detection result indicates that the target interface is misplugged, generating alarm information and sending the alarm information to an alarm device.

8. A misplug detection apparatus for high-definition multimedia interface (HDMI) device interface, applied to any HDMI device in a network, comprising:
an obtaining module, configured for obtaining a cable plug-in signal corresponding to a target interface in an HDMI device;
a determining module, configured for determining, based on the cable plug-in signal, a cable plug-in result corresponding to the target interface; and
a misplug detection module, configured for determining, based on the cable plug-in result and a target pin signal corresponding to the target interface, a misplug detection result corresponding to the target interface.

9. An electronic device, comprising a memory, a processor, and a computer program stored in the memory and executable on the processor, wherein the processor executes the computer program to implement the misplug detection method for HDMI device interface of any of claims 1 to 7.

10. A computer-readable storage medium having a computer program stored thereon, which, when executed by a processor, implements the misplug detection method for HDMI device interface of any of claims 1 to 7.
